Europäisches Patentamt

European Patent Office

Office européen des brevets

(11) Publication number: **0 555 614 A1**

# EUROPEAN PATENT APPLICATION

(21) Application number: **92810104.7**

(22) Date of filing: **13.02.92**

(51) Int. Cl.⁵: **C30B 25/14**, C23C 16/44

(43) Date of publication of application:
**18.08.93 Bulletin 93/33**

(84) Designated Contracting States:
**DE FR GB**

(71) Applicant: **International Business Machines Corporation**
**Old Orchard Road**
**Armonk, N.Y. 10504(US)**

(72) Inventor: **Roentgen, Peter, Dr.**
**Sonnenbergstrasse 40**
**CH-8800 Thalwil(CH)**
Inventor: **Broom, Ronald F., Dr.**
**Huegelstrasse 16**
**CH-8002 Zuerich(CH)**

(74) Representative: **Barth, Carl Otto et al**
**IBM Corporation Säumerstrasse 4**
**CH-8803 Rüschlikon (CH)**

(54) **Metal-organic gas supply for MOVPE and MOMBE.**

(57) Modified and improved means, serving as metal-organic sources for MOVPE and MOMBE systems, are given. These sources reduce or avoid composition fluctuations caused by bubbling action in conventional bubblers. A "bubbler" (52), being filled with a liquid metal-organic (54) is employed, such that gaseous metal-organic particles evaporate at the surface of the liquid (54). This gas is transported by a carrier gas, which is fed via an inlet tube (50) into the gas space of said "bubbler" (52), through an outlet tube (56) to a reactor where pyrolysis occurs. By the design of this "bubbler" (52), the drawbacks of the bubbling action are avoided. Additional control means are necessary to ensure proper operation of this source.

FIG. 5

EP 0 555 614 A1

TECHNICAL FIELD

The present invention concerns Metal-Organic Vapor Phase Epitaxy- (MOVPE), also known as Metal-Organic Chemical Vapor Deposition (MOCVD), and Metal-Organic Molecular Beam Epitaxy- (MOMBE) systems with improved supply of metal-organic gas. Usually, these metal-organics are situated as a liquid in a bubbler and an inert carrier gas, e.g. $H_2$ , is fed through this liquid such that gaseous metal-organics are transported out of this bubbler to the reactor. Multiple metal-organics, and therewith bubblers, are necessary depending on the material to be grown in the reactor. Very precise control of the gas flows, and the compositions of these gas flows, are required to ensure proper and reproducible growth conditions in the reactor. Fluctuations in the gas composition are detrimental to the quality of the grown material.

BACKGROUND OF THE INVENTION

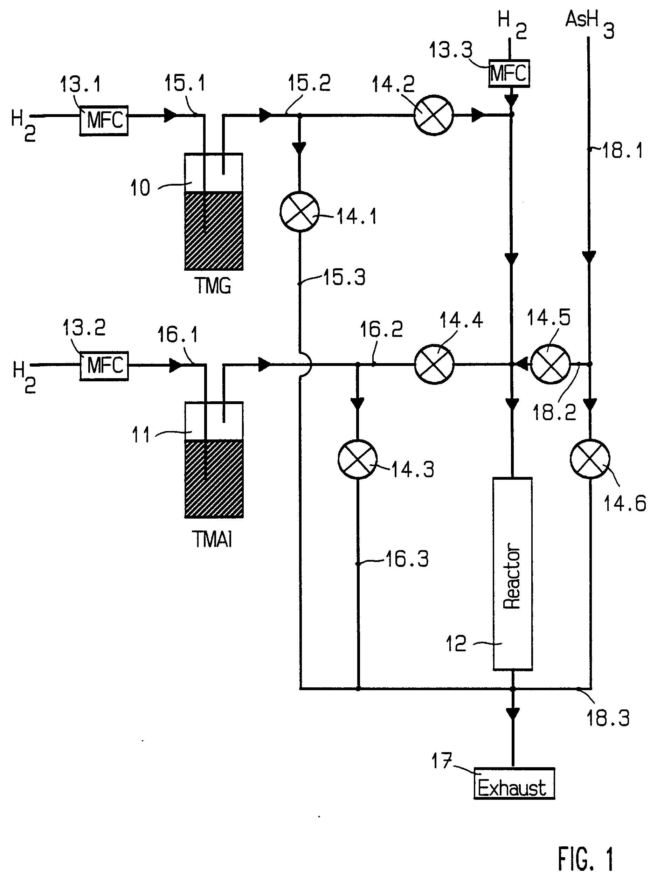

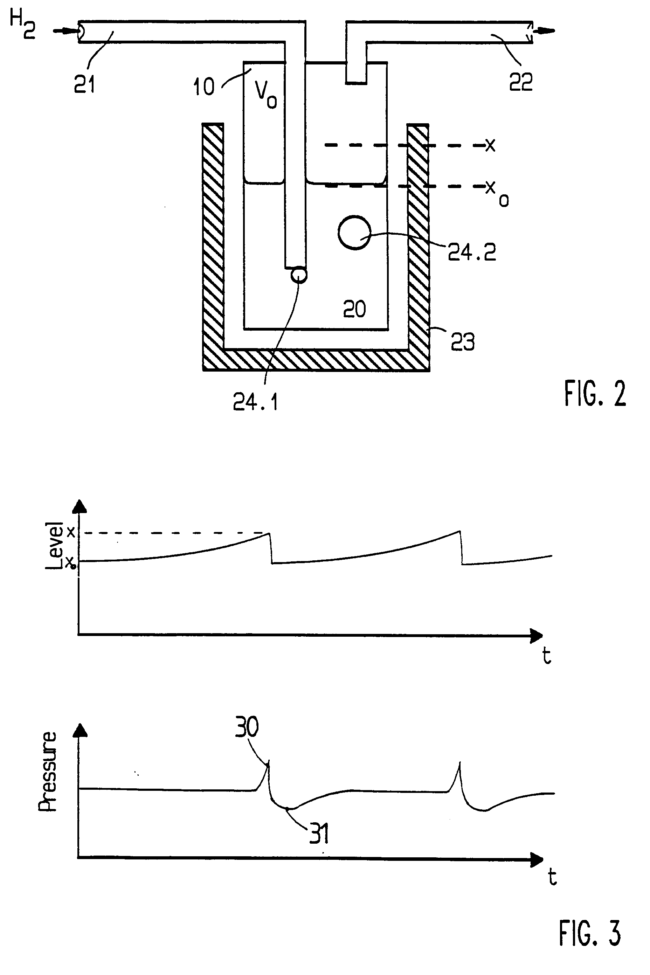

MOVPE as well as MOMBE are to date important techniques for the fabrication of semiconductor and superconductor devices. Both techniques are the best by which to grow high-quality layers, in particular semiconductor layers. Typically most metal-organic (MO) compounds are liquids and equilibrium vapor pressure is built up above this liquid. As shown in Figure 1, which is a schematic view of a typical MOVPE system, a carrier gas $H_2$ is fed via a mass flow controller 13.1 into a bubbler 10 to carry with the vapor of a metal-organic. To ensure perfect saturation of the carrier gas with the metal-organic gas, typically the inlet tube 15.1 is dipped into the metal-organic liquid. This carrier gas forms small bubbles, their size and rate depending on different parameters, which leave the end of the inlet tube 15.1 and float upwards. On reaching the surface of the liquid, they collapse and the liquid level rapidly falls to a minimum value before climbing again as the next bubble forms. This action now leads to a quasi-random series of flux pressure and concentration pulsations, at the outlet of the bubbler. This process is illustrated in Figure 2, showing a cross-section of a conventional bubbler 10. The dependency between the up and downs of the liquid and the pressure or concentration fluctuations is shown in the diagrams of Figure 3.

The same problem occurs in MOMBE system, being a combination of conventional MBE (Molecular Beam Epitaxy) with metal-organic sources. A MBE system with metal-organic bubbler is described in the article "The operation of Metalorganic Bubblers at Reduced Pressure", S.D. Hersee et al., Journal Vacuum Science & Technology A, Vol. 8, No. 2, March/April 1990 pp. 800 - 804. This deficiency of known systems, the composition fluctuation due to a non uniform metal-organic's flow, has been reported on, for the first time, in the article "Compositional Transients in MOCVD Grown III-V Heterostructures", by E.J. Thrush et al., Journal of Crystal Growth, Vol. 68, 1984, pp. 412 - 421. By use of an acoustic transducer, in combination with an amplifier and a fast response Y-T recorder, the bubble rate has been measured and plotted by the authors at various carrier gas flow rates. Irregularities at low carrier gas flow rates, induction periods before bubbling starts, and immediate bubbling stops when switching the carrier gas to by-pass, have been shown. Some details of the physics of the bubbling action are given in the article "Systems Approach to Liquid-Source Deposition and Diffusion Technology; An Overview for the 90s", H.J. Boeglin et al., Microelectronic Manufacturing and Testing, April 1990, pp. 23 - 26.

The effect of composition fluctuations due to a raising and falling liquid level has been reported on in the article "Growth and characterization of GaAlAs/GaAs and GaInAs/InP structures: The effect of a pulse metalorganic flow", M. Sacilotti et al., Journal of Applied Physics, Vol. 71, No. 1, Jan. 1992, pp. 179 - 186. This article is a follow-up article of "Effect of Metal-Organic Composition Fluctuation on the Atmospheric-Pressure Metal-Organic Vapor Phase Epitaxy Growth of GaAlAs/GaAs and GaInAs/InP Structures", P. Ossart et al., which has been published in Japanese Journal of Applied Physics, Vol. 30, No. 5A, May 1991, pp. L783 - L785. In both these articles it has been shown that some metal-organic sources cause nonlinearities between layer thickness and growth time and layers striations. These effects are correlated to the pulse character of the MO flow. In this and the following articles it has been proposed to operate the sources with a high $H_2$ flow rate, or to employ a diffuser as described by A. Mircea et al. in their article "Instrumental Aspects of Atmospheric Pressure MOVPE Growth of InP and InP-GaInAsP Heterostructures", Journal of Crystal Growth, Vol. 77, 1986, pp. 340 - 346. Another proposal is to include an orifice within the pipeline of the source, to overcome these detrimental effects.

In the diffuser described by A. Mircea et al., the metal-organic liquid is covered by a flow barrier, called frit, to deliver the wanted output. Gaseous metal-organic has to diffuse through this flow barrier, prior to be carried away by the carrier gas flow. This diffusion through the barrier is critical because it depends on various parameters such as liquid level, vapor pressure, temperature, and diffusion coefficient. The diffusion coefficient may change with increasing pollution of the barrier. These drawbacks make the use of a diffuser, instead of a conventional bubbler, impractical. In addition, filling the diffuser, to ensure a certain liquid level, is complicated and expensive. Diffusers, like the one described in the article of Mircea et al., are not available on the market such that they have to be made and filled individually. Another disadvantage of the diffuser is that it is not easy to refill. The inlet port for filling it is situated on top of the bubbler, such that the liquid has to be fed through a very small hole of the frit into its lower part.

No prior art is known providing for simple and efficient improvements of the known bubblers to reduce the composition fluctuations.

## SUMMARY OF THE INVENTION

The main object of this invention is to provide a gas supply system with reduced or without composition fluctuations.

Another object of this invention is to provide a gas supply system which can simply replace an existing supply system without substantial changes of the whole equipment.

A further object of the present invention is to provide a gas supply system which ensures efficient and constant output of metal-organics without requiring additional control or complicated refilling of the sources.

A further object is to provide for improvements of conventional bubblers.

This has been accomplished by providing for a modified design of known bubblers and/or inserting, if required, additional means between bubbler and reactor. Only slight changes of known systems are necessary, thus reducing the potential danger of a leaking system, avoiding contaminations, and further reducing the costs when modifying a system.

## DESCRIPTION OF THE DRAWINGS AND SHORT FORMS

The invention is described in detail below with reference to the following drawings which are schematic and not drawn to scale, while more particularly the dimensions of some parts are exaggerated for the sake of clarity.

FIG. 1 is a schematic view of a conventional MOVPE system with TMG (TriMethylGallium) and TMAl (TriMethylAluminium) bubblers.

FIG. 2 Is a schematic cross-sectional view of a conventional bubbler.

FIG. 3 is a simplified diagram showing the variations of the liquid level and the pressure fluctuation plotted versus time.

FIG. 4 is a TEM picture of an InGaAs layer grown on an InP layer, using conventional bubblers, TMG (TriMethylGallium) and TMIn (TriMethylIndium).

FIG. 5 is cross-sectional view of a "bubbler" in accordance with the first embodiment of the present invention.

FIG. 6 is a cross-sectional view of a baffle tube in accordance with the second embodiment of the present invention.

FIG. 7 is a schematic view of a modified outlet tube with damper and bypass line, in accordance with the third embodiment of the present invention.

FIG. 8 is a schematic cross-sectional sketch of a bubbler with modified inlet tube, in accordance with the fourth embodiment of the present invention.

FIG. 9 is a TEM picture of a GaInAs layer on InP, using TEG (TriEthylGallium) in place of TMG to raise the $H_2$ flow rate through the bubbler by a factor of about 20.

FIG. 10 is a schematic cross-sectional sketch of a bubbler with modified inlet tube, in accordance with the present invention.

FIG. 11 is a schematic cross-sectional sketch of a necked-down portion being inserted into the outlet tube of a source, in accordance with the present invention.

## GENERAL DESCRIPTION

A typical MOVPE system, configured for epitaxial growth of GaAs/AlGaAs, is shown in Figure 1. Two metal-organic sources, bubblers 10 and 11, are connected to a reactor 12 where the epitaxy takes place. These sources are kept nominally at a constant pressure and temperature. $H_2$ is used as carrier gas and is fed via two mass-flow controllers (MFCs) 13.1 and 13.2 and inlet tubes 15.1 and 16.1 to the respective bubblers 10, 11. The first bubbler 10 is partly filled with trimethylgallium (TMG), the second bubbler 11 with trimethylaluminium (TMAl). The outlet tube 15.2 of TMG bubbler 10, is connected via a valve 14.2 to the reactor 12. An additional tube 15.3, called ventilation tube, is employed for ventilation purposes. This ventilation tube 15.3 can be opened by means of a ventilation valve 14.1 and feeds gas, when not being switched to the reactor 12 to an exhaust 17. The second bubbler 11 is in the same manner connected to the reactor 12, a valve 14.4 separating its outlet tube 16.2 from the reactor 12. The ventilation tube 16.3, of bubbler 11, is connected via ventilation valve 14.3 to the exhaust 17. An additional $H_2$ gas flow, which is fed via mass-flow controller 13.3 to the reactor 12, can be employed for different reasons, such as flushing out the reactor before starting the epitaxy, or as an additional carrier gas being added to the slower gas flows through the bubblers 10 and 11. In addition, a hydride, such as arsine $AsH_3$, is fed to the reactor 12 via tubes 18.1 and 18.2. Again, a combination of two valves, 14.5 and 14.6, allows to bypass the reactor 12 via ventilation tube 18.3, or to feed the hydride into the reactor 12 via valve 14.5, as shown in Figure 1.

As illustrated in Figure 2, a carrier gas $H_2$ is fed via an inlet tube 21 into the metal-organic liquid 20 situated in bubbler 10. At the end of the inlet tube 21, which is dipped into the liquid, a bubble 24.1 starts to form. The size of this bubble 24.1 depends on the surface tension of the liquid, its temperature, density, pressure, and the inlet tube diameter. The temperature , must be controlled, e.g by using a temperature bath 23. As the bubble 24.1 reaches its maximum size, it leaves the tube 21 and floats towards the surface of the liquid. At the same time another bubble 24.2 is about to float upwards. The surface of the liquid rises since the bubbles displace the liquid. With bubbles growing in the liquid, the gas volume $V_0$ decreases, while the level of the liquid rises from mark $x_0$ up to the mark x. The bubbles collapse when reaching the surface and the level of the liquid falls. A collapsing bubble causes a short positive pressure peak 30, shown in the lower diagram of Figure 3. The displacement of the liquid and therewith the variation of the gas volume $V_0$ leads to a regular series of negative pressure pulsations 31, in the outlet tube 22. A good illustration of this pressure pulses is given in the above cited article of P. Ossart et al., see Figure 1 thereof.

In addition, the concentration of the MO gas in a bubble is usually greater than in the gas space above the liquid, causing further concentration pulses when these bubbles collapse. A superposition of these effects, the collapsing bubble and the displacement of the liquid by the growing bubbles, results in the pressure versus time curve shown in Figure 3. These variations of the output pressure and concentration cause fluctuations of the gas composition in the outlet tube 22.

The flow of a metal-organic alkyl, at the outlet of a bubbler, can be described as follows:

$$F_{MO} \sim \frac{F_{Carrier}\, p_{Vapor}(MO, T)}{p_{Bubbler}} \qquad (1)$$

To achieve adequate flows $F_{MO}$ of different metal-organics, such as TMG and TEG, having different vapor pressures (see Table 1), the carrier gas flow $F_{Carrier}$ has to be adapted accordingly. For the same partial pressure, the metal-organics with low vapor pressure for example do require a smaller carrier gas flow than metal-organics with high vapor pressure.

To form a solid ternary composition, which can generally be described by $A_x B_{x-1} C$, one has to ensure proper growth conditions as can be seen from:

$$[A]_{sol} \sim \frac{[F_{MOA}]}{[F_{MOA}] + [F_{MOB}]} \qquad (2)$$

To achieve an accuracy of the concentration of 'A' better than 1% the accuracy of the MO flow $F_{MO}$ has to be better than 1%. This shows the influence of a compositional fluctuation in the MO gas flow on the composition of the solid to be grown.

Dilute vapors of the metal-organics and other members of the reaction are transported at, or near, room temperature to a hot zone in the reactor 12 where a pyrolysis reaction occurs. In our case, e.g., gallium arsenide is formed by feeding TMG and arsine $AsH_3$ to the reactor 12. By heating these chemicals over a suitable substrate placed in the reactor 12, the following reaction takes place:

$(CH_3)_3 Ga_2 + AsH_3 \rightarrow GaAs + 3CH_4$    (3)

This simplified reaction ignores any intermediate steps that may occur. Detailed models of the accurate process are reported in the articles "Detailed Models of the MOVPE Process", K.F. Jensen, Journal of Crystal Growth, Vol. 107, 1991, pp. 1 - 11, and in "Modeling of Chemical Vapor Deposition", J. Korec et al., Journal of Crystal Growth, Vol. 60, 1982, pp. 286 - 296.

Some of the chemicals which are used for the epitaxy of III-V and II-VI compound semiconductors are listed in Table 1. In addition, their vapor pressures, and melting points are given in this table.

Table 1

| Chemicals to be used in MOVPE or MOMBE | | | | |
|---|---|---|---|---|
| Compound | Formula | Abbrev. | Vapor Press. [torr] at 20°C | Melt. Point [ °C ] |
| Dimethylzinc | $(CH_3)_2 Zn$ | DMZn | 302,5 | -42 |
| Diethylzinc | $(C_2H_5)_2 Zn$ | DEZn | 12,2 | -28 |
| Trimethylaluminium | $(CH_3)_3 Al$ | TMAl | 8,7 | 15,4 |
| Triethylaluminium | $(C_2H_5)_3 Al$ | TEAl | 0,02 | -52,5 |
| Trimethylgallium | $(CH_3)_3 Ga$ | TMG | 182,3 | -15,8 |
| Triethylgallium | $(C_2H_5)_3 Ga$ | TEG | 4,41 | -82,3 |
| Trimethylindium | $(CH_3)_3 In$ | TMIn | 1,71 | 88 |
| Triethylindium | $(C_2H_5)_3 In$ | TEIn | 0,21 | -32 |

More details on these and other chemicals are given in the book "The MOCVD Challenge", M. Razeghi, Volume 1: A survey of GaInAsP:InP for Photonic and Electronic Applications, Adam Hilger, Bristol and Philadelphia, 1989, and in the Alfa Ventron Catalogue "Organometallics for Vapor Phase Epitaxy", Literature & Product Review, Ventron Alfa Products, Division of Morton Thiokol, GmbH, Zeppelinstraße 7, Postfach 6540, 7500 Karlsruhe 1, Germany.

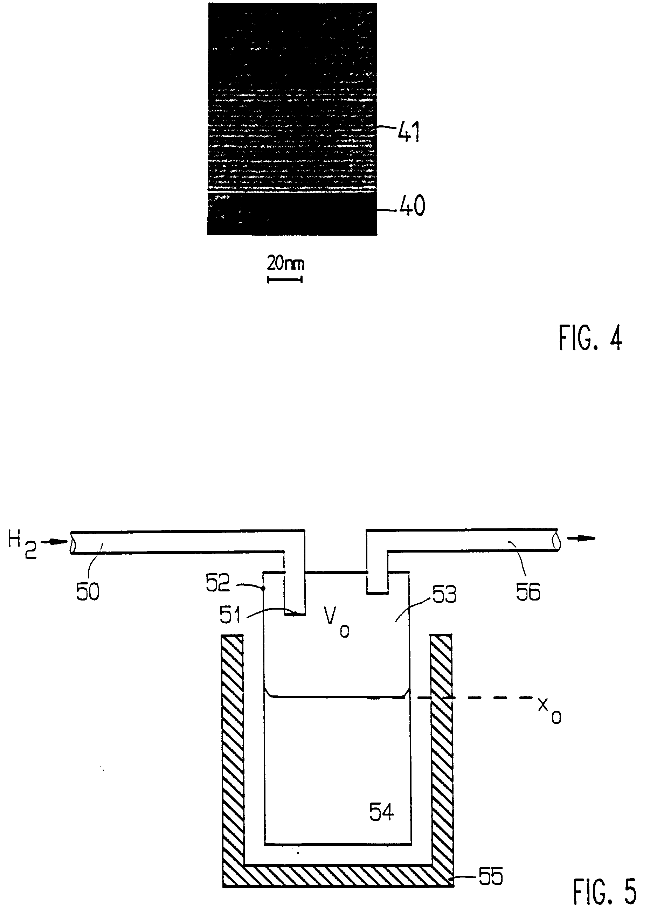

In the growth of binary compounds, such as GaAs or InP, small pressure fluctuations are of no great importance because the growing surface is usually stabilized by an excess of one element. However, for ternary or quaternary compounds, such as GaInAs or AlGaInP, the pulsations lead to variations in composition. These variations of composition are illustrated by the picture shown in Figure 4. Figure 4 is a cross-sectional view of an InGaAs layer 41, grown on top of an InP layer 40. This picture is made by TEM (Transmission Electron Microscopy). The dark bands which appear in layer 41 are due to an excess of In (deficit of Ga) in the InGaAs. Such unintentional variations in composition are deleterious to the quality of the layers because they introduce strain and bandgap modulations perpendicular to the surface. These effects in turn, degrade the optical and electrical properties, for example broadening of the recombination spectrum, and increase of the electrical resistance through carrier depletion in the regions of higher bandgap.

The first embodiment of the present invention is hereinafter described in context with Figure 5. A schematic sketch of a "bubbler" 52, being situated in a temperature bath 55, is illustrated in this Figure. The inlet tube 50 is shorter than the one being conventionally used. The end 51 of inlet tube 50 does not touch the liquid 54. An outlet tube 56 transports gas out of the gas space 53 above the liquid 54. In this system no bubbling action occurs. For high vapor pressure MOs and low carrier gas flow rates, a steady state exchange establishes between the liquid 54 and the gas space 53. The carrier gas flow, fed into this gas space 53, transports gaseous metal-organics, via tube 56, out of the "bubbler" 52.

Only slight modifications of known systems are necessary when replacing a conventional bubbler by the inventive one. A precise control of the carrier gas flow guarantees proper operation of this supply system without any pressure fluctuations due to bubbles.

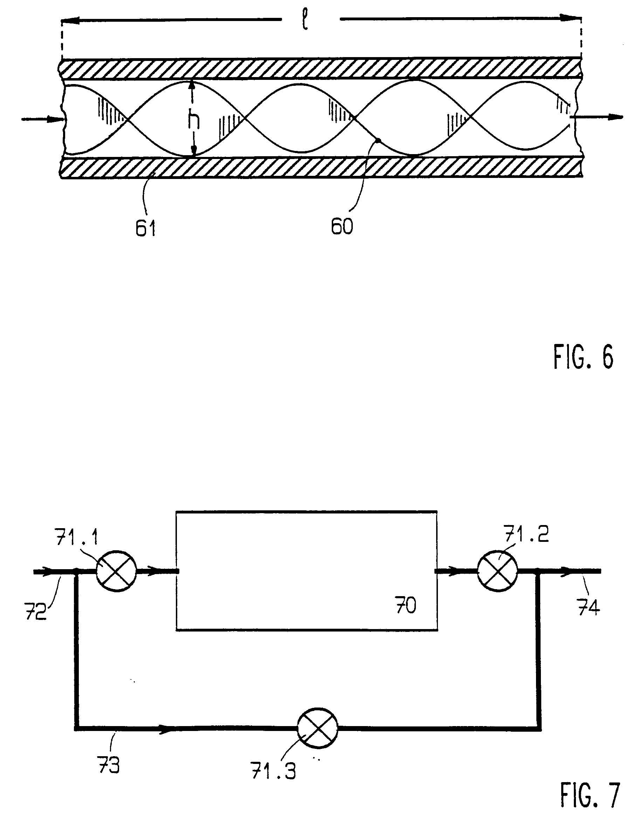

A second embodiment is shown in Figure 6. A cross-sectional sketch of a baffle tube 61 is shown, which may be inserted between a conventional bubbler or the "bubbler" of the first embodiment, and the reactor. This baffle tube 61 is filled with means to cause a turbulent gas flow. Caused by this, a uniform mixture of the gas is achieved. The baffle tube 61 can be filled with a twisted flat strip of stainless steel 60, or steel wool, coiled wire, or glass spiral, for example. The length l and diameter h of the baffle tube 61 can be modified as required.

A third embodiment is illustrated in Figure 7. A damper 70, situated between the outlet 72 of a bubbler and the reactor, both not shown, provides for an enlarged volume and therewith reduced flow rate between bubbler and reactor. By the means of this damper 70, the pressure fluctuations are reduced. A disadvantage of a system with enlarged volume is that it cannot be used for abrupt transitions. These abrupt transitions are important when growing e.g. thin quantum well layers with varying compositions. Fast composition changes, such as switching from a 10% Al content to a 50% Al content, are not possible with this damper. As shown in Figure 7, this drawback can be avoided by providing for a bypass 73. The gas flow can be directed from the bubbler via bypass 73, with the valves 71.2 and 71.2 being closed and the bypass valve 71.3 being open.

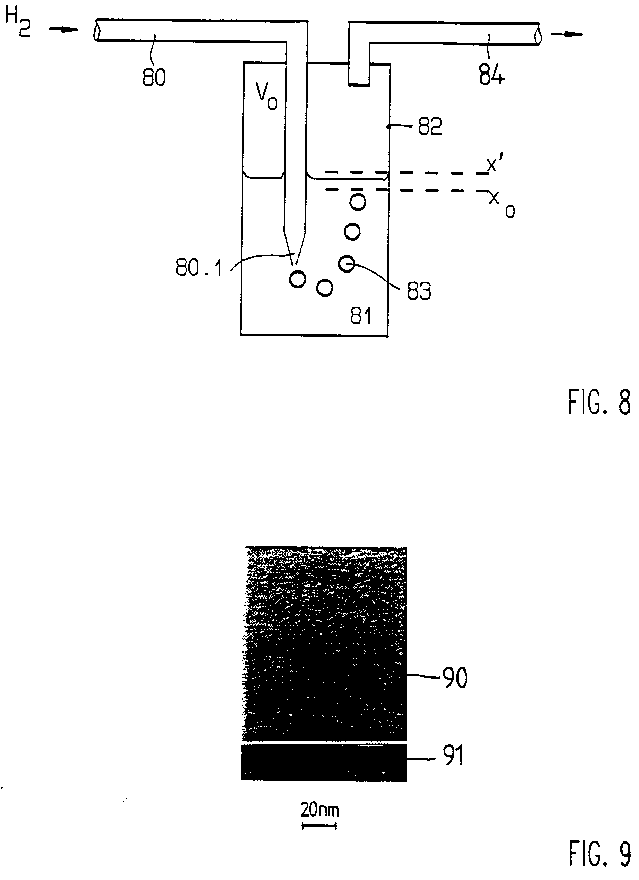

The fourth embodiment is shown in Figure 8. The inlet tube of a conventional bubbler 82 has been modified such that it has a decreased diameter at its end 80.1. This modified tube 80, shown in Figure 8, can be dipped into a metal-organic liquid 81. By the reduction of the diameter, the size of the bubbles 83 is reduced and their rate is increased. This leads to shallow pressure fluctuations of high frequency (f) in the outlet tube 84. The distance between the fronts of the concentration pulses in the outlet pipe of this modified system is very short ($\lambda$ = 1/f) and the variations in composition are negligible. The liquid level is only changing between $x_0$ and x', with x' < < x (see Figures 2 and 8).

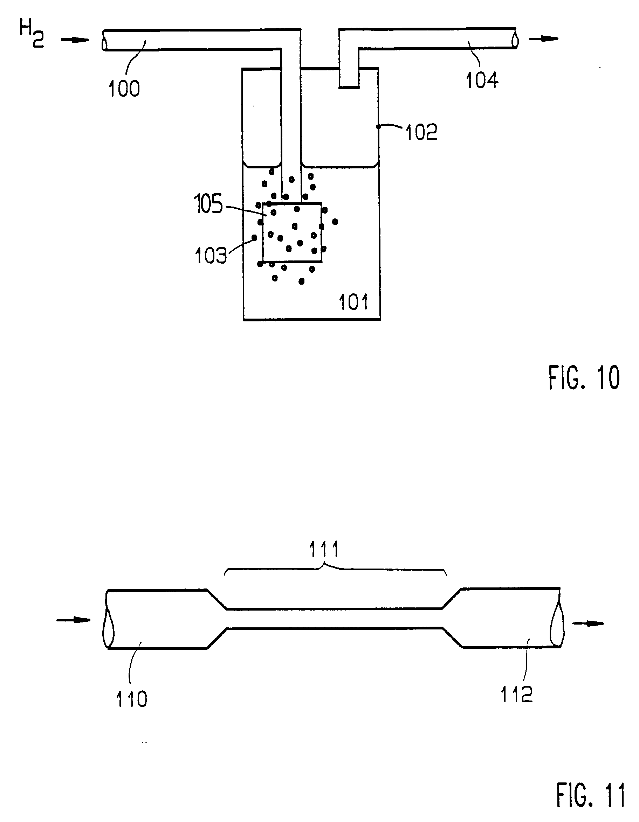

Another means, for reducing the size of the bubbles and increasing the bubble rate, is illustrated in Figure 10. The inlet tube 100, of this modified bubbler 102 has porous means 105 at its outlet being dipped into the metal-organic liquid 101, such that many small bubbles 103 are generated. Said porous means 105 preferably consists of $Al_2O_3$ or other suitable materials. This ensures a high frequency of bubbles, the average magnitude of the composition fluctuations in the outlet tube 104 being very small.

Another means, reducing the composition fluctuation, may be inserted into the outlet tube 110 of a source as shown in Figure 11. By providing for a tube with necked-down portion 111, the laminar gas flow in the outlet tube 110 of this source increases its velocity. By this, the gas flow becomes turbulent, resulting in less compositional fluctuations at the outlet 112 of the necked-down portion 111. If required, this necked-down portion 111 can be bypassed employing three valves as shown in Figure 7.

Additional means may be employed controlling parameters of these sources, modified in accordance with the present invention, to ensure proper operation. The most important parameters are the mass flow of the carrier gas, the temperature of the bubbler and the pressures at different places within the system. For instance, the first embodiment requires exact control of the processes in the bubbler such that a steady state establishes. If the temperature is too low, the evaporation of gaseous metal-organics is not able to replace the particles which have been transported out of the bubbler, such that the steady state of the whole system is disturbed. This results in a decreasing concentration of gaseous metal-organics in the outlet gas flow.

In summary, any combination of the above described elements can be employed and will lead to more uniform materials with a consequent improvement in both optical and electrical parameters which are of critical importance for todays and future device applications. Confirmation of the cause of layering, shown in Figure 4, is given by the result of Figure 9. In the picture of this Figure, a InGaAs layer 90 is shown, which has been grown with an MOVPE system and a TEG metal-organic source and 20 fold $H_2$ gas flow causing a higher bubble rate, on top of an InP layer 91. In this case the layering is totally absent.

## Claims

1. Metal-organic source, in particular as part of a Metal-Organic Vapor Phase Epitaxy (MOVPE) system or Metal-Organic Molecular Beam Epitaxy (MOMBE) system, said metal-organic source comprising a bubbler (10; 52; 82; 102) partly filled with a metal-organic liquid (20; 54; 81; 101), said bubbler (10; 52; 82; 102) having an inlet tube (21; 50; 80; 100) and an outlet tube (22; 56; 72; 84; 104), said metal-organic source further comprising a carrier gas source feeding a carrier gas through said inlet tube (21; 50; 80; 100) into said bubbler (10; 52; 82; 102), said metal-organic source being characterized by
   - means for reducing (50; 80.1; 105; 111) or avoiding (60, 61; 70 - 74) compositional fluctuations of gaseous metal-organics at the output of said metal-organic source;
   - means for controlling the mass flow of said carrier gas, and
   - means for controlling the temperature of said bubbler and/or operating said bubbler at a suitable temperature.

2. Metal-Organic Vapor Phase Epitaxy (MOVPE) system or Metal-Organic Molecular Beam Epitaxy (MOMBE) system having at least one metal-organic source, comprising:
   - a bubbler (10; 52; 82; 102) partly filled with a metal-organic liquid (20; 54; 81; 101), said bubbler (10; 52; 82; 102) having an inlet tube (21; 50; 80; 100) and an outlet tube (22; 56; 72; 84; 104);
   - a carrier gas source feeding a carrier gas through said inlet tube (21; 50; 80; 100) into said bubbler (10; 52; 82; 102);

- means for reducing (50; 80.1; 105; 111) or avoiding (60, 61; 70 - 74) compositional fluctuations of gaseous metal-organics at the output of said metal-organic source;
- means for controlling the mass flow of said carrier gas, and
- means for controlling the temperature of said bubbler and/or operating said bubbler at a suitable temperature.

3. The metal-organic source of claims 1 or 2, characterized in that said means for avoiding fluctuations of gaseous metal-organics consists of a shortened inlet tube (50) which does not contact the metal-organic liquid (54) in said bubbler (52), such that no bubbling action occurs.

4. The metal-organic source of claims 1 or 2, characterized in that said means for reducing fluctuations of gaseous metal-organics comprises an inlet tube (80) having a reduced diameter at its end (80.1), which is dipped into the metal-organic liquid (81), providing for an increased carrier gas flow velocity and therewith a reduced bubble size and increased bubble rate.

5. The metal-organic source of claims 1 or 2, characterized in that said means for reducing fluctuations of gaseous metal-organics comprises an inlet tube (100) having a porous means (105) at its end, which is dipped into the metal-organic liquid (101), providing for an increased carrier gas flow velocity and therewith a reduced bubble size and increased bubble rate.

6. The metal-organic source of claims 1 or 2, characterized in that said means for reducing fluctuations of gaseous metal-organics comprises a baffle tube (61) which is inserted into the outlet tube.

7. The metal-organic source of claim 6, characterized in that said baffle tube (61) is filled with a twisted flat strip of stainless steel (60), or stainless steel wool, or a stainless steel coil, or a glass spiral, or any combination thereof.

8. The metal-organic source of claims 1 or 2, characterized in that said means for reducing fluctuations of gaseous metal-organics comprises a necked-down portion (111) which is inserted into the outlet tube (110).

9. The metal-organic source of claims 1 or 2, characterized in that said means for reducing fluctuations of gaseous metal-organics comprises a damper (70) with enlarged volume inserted into said outlet tube (72).

10. The metal-organic source of claims 8 or 9, characterized in that said means for reducing fluctuations of gaseous metal-organics comprises bypass means (71.1 - 71.3, 73) employed to bypass it when fast switching from one composition to another is required.

11. The metal-organic source of any preceding claims, characterized in that said means for controlling the mass flow of said carrier gas, said means for controlling the temperature of said bubbler, and said means for operating said bubbler at a suitable temperature, are employed such that a steady state of evaporation, sublimation and transport by the carrier gas establishes in the bubbler.

12. Method for improving a Metal-Organic Vapor Phase Epitaxy (MOVPE) system or Metal-Organic Molecular Beam Epitaxy (MOMBE) system having at least one metal-organic source, said metal-organic source comprising: a bubbler partly filled with a metal-organic liquid, said bubbler having an inlet tube and an outlet tube, and further comprising a carrier gas source feeding a carrier gas through said inlet tube into said bubbler, said method being characterized by
   - reducing or avoiding compositional fluctuations of gaseous metal-organics at the output of said metal-organic source.
   - controlling the mass flow of said carrier gas, and
   - controlling the temperature of said bubbler and/or operating said bubbler at a suitable temperature.

13. The method of claim 12, wherein said carrier gas is fed into the gas space above the metal-organic liquid in said bubbler such that no bubbling action occurs.

**14.** The method of claim 12 characterized by providing for an increased bubbling rate and/or a reduced size of bubbles.

FIG. 1

FIG. 2

FIG. 3

20mm

FIG. 4

FIG. 5

FIG. 6

FIG. 7

FIG. 8

20nm

FIG. 9

$H_2$

100

102

105

103

101

104

FIG. 10

111

110

112

FIG. 11

European Patent
Office

**EUROPEAN SEARCH REPORT**

Application Number

EP    92 81 0104

Page  1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | PATENT ABSTRACTS OF JAPAN<br>vol. 15, no. 238 (C-841)19 June 1991<br>& JP-A-3 075 295 ( MITSUBISHI ELECTRIC CORP ) 29 March 1991<br>* abstract * | 1-3,12, 13 | C30B25/14<br>C23C16/44 |
| X | PATENT ABSTRACTS OF JAPAN<br>vol. 15, no. 154 (C-825)18 April 1991<br>& JP-A-3 031 477 ( OKI ELECTRIC CO LTD ) 12 February 1991<br>* abstract * | 1,2,5, 12,14 | |
| X | PATENT ABSTRACTS OF JAPAN<br>vol. 15, no. 306 (C-856)6 August 1991<br>& JP-A-3 112 892 ( CANON INC ) 14 May 1991<br>* abstract * | 1,2,12, 14 | |
| X | PATENT ABSTRACTS OF JAPAN<br>vol. 15, no. 306 (C-856)6 August 1991<br>& JP-A-3 112 893 ( CANON INC ) 14 May 1991<br>* abstract * | 1,2,12, 14 | |
| Y | GB-A-2 008 084 (THE POST OFFICE)<br><br>* figure 2 * | 1,2,4, 11,12,14 | TECHNICAL FIELDS SEARCHED (Int. Cl.5 )<br><br>C30B<br>C23C |
| Y | US-A-4 393 013 (MCMENAMIN)<br><br>* column 2, line 36 - line 45 * | 1,2,4, 11,12,14 | |
| Y | US-A-4 911 101 (BALLINGALL)<br><br>* claim 1 * | 1,2,4, 11,12,14 | |
| A | EP-A-0 311 446 (MITSUBISHI RAYON CORP) | | |
| A | EP-A-0 175 601 (MELLET) | | |
| A | EP-A-0 283 874 (MERCK PATENT GESELLSCHAFT)<br>* column 4, line 39 - line 50 * | 1,5 | |

The present search report has been drawn up for all claims

| Place of search | Date of completion of the search | Examiner |
|---|---|---|
| THE HAGUE | 11 SEPTEMBER 1992 | COOK S.D. |

EPO FORM 1503 03.82 (P0401)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| | --- | | |
| A | EP-A-0 360 327 (LABORATOIRES D'ELECTRONIQUE PHILIPS) | | |
| | --- | | |
| A | EP-A-0 113 518 (THIOKOL CORPORATION) | | |
| | ----- | | |

TECHNICAL FIELDS
SEARCHED (Int. Cl.5 )

The present search report has been drawn up for all claims

| Place of search | Date of completion of the search | Examiner |
|---|---|---|
| THE HAGUE | 11 SEPTEMBER 1992 | COOK S.D. |